# EUROPEAN PATENT APPLICATION

(11) **EP 2 242 107 A1**
(43) Date of publication of application: **20.10.2010**
(21) Application number: 09707543.6
(22) Date of filing: 06.02.2009
(51) Int. Cl.: H01L 29/78, H01L 29/12, H01L 29/739

(54) **SEMICONDUCTOR DEVICE**

(30) Priority: 06.02.2008 JP 2008026973
(71) Applicant: Rohm Co., Ltd., Kyoto 615-8585 (JP)
(72) Inventor: OTSUKA, Takukazu, Kyoto-shi Kyoto 615-8585 (JP); MITANI, Shuhei, Kyoto-shi Kyoto 615-8585 (JP)
(74) Representative: TBK-Patent
(86) International application number: PCT/JP2009/052050
(87) International publication number: WO 2009/099182

(57) **Abstract**

Provided is a semiconductor device which has improved withstand voltage and can be manufactured by simpler manufacturing process. The semiconductor device according to the present invention includes: a SiC-containing n-type epitaxial layer 1 which is stacked on a surface of the n⁺-type substrate 11 containing SiC; n⁺-type source regions 5 arranged away from each other in a surface layer of the epitaxial layer 1; a p-type well contact region 2 sandwiched by the source regions 5; a p-type well region 3 arranged in contact with surfaces of the source regions 5 and p-type well contact region 2 on the substrate 11 side; and p-type well extension regions 4 arranged to sandwich the source regions 5 and p-type well region 3. The impurity concentration of the p-type well region 3 has a peak concentration at a position deeper in the depth direction from the surface of the epitaxial layer 1 toward the substrate 11 than the position of a peak concentration of the p-type well extension regions 4.

## Description

### TECHNICAL FIELD

The present invention relates to a semiconductor device and specifically to a semiconductor device using silicon carbide.

In recent years, there have been developed semiconductor devices for power conversion using a MOSFET (a metal oxide semiconductor filed effect transistor) or an IGBT (an insulated gate bipolar transistor) as a power semiconductor element. Among such semiconductor devices, semiconductor devices including silicon carbide (SiC) semiconductors have particularly received attention because of the band gap of SiC wider than that of silicon (Si), the breakdown electric field of an order of magnitude higher than that of Si, and the like.

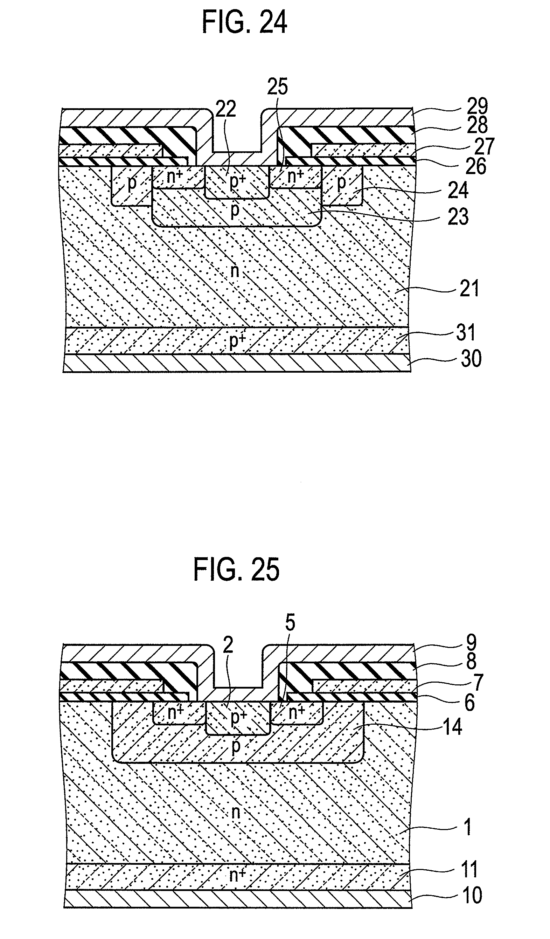

Fig. 25 shows an example of a structure of a conventional power MOSFET using SiC. In the conventional power MOSFET, an n⁻-type SiC semiconductor epitaxial layer 1 is provided on a surface of an n⁺-type SiC semiconductor substrate 11. In a surface layer portion of the n⁻-type SiC semiconductor epitaxial layer 1, a p-type impurity region 14 and n⁺-type impurity regions 5 within the p-type impurity region 14 are provided. The n⁺-type impurity regions 5 sandwich a p⁺-type impurity region 2.

For forming impurity regions in a SiC semiconductor, an ion implantation process has usually been used since the impurity regions are difficult to form by a thermal diffusion process, which is used for Si semiconductors (see Patent Literature 1, for example).
Patent Literature 1: Japanese Patent Application Publication No. 2002-299620

### DISCLOSURE OF THE INVENTION

### PROBLEMS TO BE SOLVED BY THE INVENTION

In a MOSFET including SiC, however, as the impurity concentration of the p-type impurity region 14 increases near the interface with a gate insulating film 6 (a channel region), the mobility in the channel region decreases. In order to reduce the impurity concentration near the surface of the p-type impurity region 14, it is necessary to suppress the overall impurity concentration of the p-type impurity region 14 by reducing the dose of implanted impurity ions. As a result, when reverse voltage is applied, punch through occurs in the p-type impurity region 14. Accordingly, there has been a problem in that the MOSFET including SiC can neither take advantage of original breakdown electric field of SiC nor have high withstand voltage.

If each of a guard ring and p- and n-type impurity regions is formed using a different mask, there arise problems in that the number of manufacturing processes is increased, and the yield is reduced.

An object of the present invention is to provide a semiconductor device which has improved withstand voltage characteristics and can be manufactured with a simpler manufacturing process.

### MEANS FOR SOLVING THE PROBLEM

In order to achieve the above object, according to one aspect of the present invention, there is provided a semiconductor device comprising: a substrate which contains silicon carbide and includes a first main electrode region; a first conductivity-type epitaxial layer which is stacked on the a front surface of the substrate and is made of silicon carbide; first conductivity-type second main electrode regions arranged away from each other in a surface layer of the epitaxial layer; a second conductivity-type well contact region sandwiched by the second main electrode regions; a second conductivity-type well region arranged in contact with surfaces of the second main electrode regions and the second conductivity-type well contact region on the substrate side; second conductivity-type well extension regions arranged to sandwich the second main electrode regions and the second conductivity-type well region; gate electrodes arranged on surfaces of the second conductivity-type well extension regions with gate insulating films interposed therebetween, each second conductivity-type well extension region being sandwiched by the corresponding one of the second main electrode regions and a surface exposed portion of the epitaxial layer; a second main electrode arranged in contact with surfaces of the second main electrode regions and the second conductivity-type well contact region in a shared manner; and a first main electrode arranged on a rear surface of the substrate opposite to the front surface, wherein concentration of a second conductivity-type impurity contained in the second conductivity-type well region has a peak concentration at a deeper position than the position of a peak concentration of the second conductivity-type impurity contained in the second conductivity-type well extension regions in a depth direction from the surface of the epitaxial layer toward the substrate.

### EFFECT OF THE INVENTION

According to the present invention, it is possible to provide a semiconductor device which has improved withstand voltage characteristics and can be manufactured with a simpler manufacturing process.

### BRIEF DESCRIPTION OF THE DRAWINGS

[Fig. 1] Fig. 1 is a schematic cross-sectional view of a semiconductor device according to a first embodiment of the present invention.
[Fig. 2] Fig. 2 is a schematic plan view of Fig. 1.
[Fig. 3] Fig. 3 is an explanatory view of a method of manufacturing the semiconductor device according to the first embodiment of the present invention: (a) being a view of a process of forming an epitaxial layer 1 on a front surface of a substrate 11; (b) being a view of a process of forming a p-type well extension region 4 in a surface layer portion of the epitaxial layer 1 using a p-type mask which allows a guard ring portion to be simultaneously formed; and (c) being a view of a process of forming a p-type well region 3 in the surface layer of the epitaxial layer 1 using an n-type mask.
[Fig. 4] Fig. 4 is an explanatory view of the method of manufacturing the semiconductor device according to the first embodiment of the present invention: (d) being a view of a process of forming n⁺-type source regions 5 and a p-type well contact region 2 using an n-type mask; (e) being a view of a process of forming a gate insulating film 6 and then forming a gate electrode 7; and (f) being a view of a process of forming an interlayer insulating layer 8 and then forming a source electrode 9.
[Fig. 5] Fig. 5 is a chart showing impurity concentration in the depth direction in a semiconductor device doped with an ion implantation energy of 380 keV and a dose of 3.6×10¹³ cm⁻².
[Fig. 6] Fig. 6 is a chart showing impurity concentration in the depth direction in a semiconductor device doped with an ion implantation energy of 300 keV and a dose of 1.8×10¹³ cm⁻².
[Fig. 7] Fig. 7 is a chart showing impurity concentration in the depth direction in a semiconductor device doped with an ion implantation energy of 300 keV and a dose of 6.0×10¹² cm⁻².
[Fig. 8] Fig. 8 is a chart showing impurity concentration in the depth direction in a semiconductor device doped with an ion implantation energy of 250 keV and a dose of 1.8×10¹³ cm⁻².
[Fig. 9] Fig. 9 is a chart showing impurity concentration in the depth direction in a semiconductor device doped with an ion implantation energy of 200 keV and a dose of 8.0×10¹² cm⁻².
[Fig. 10] Fig. 10 is a view showing shape models of simulation: (a) being a view of the shape model of the semiconductor device according to the first embodiment of the present invention; and (b) being a view of the shape model of a conventional semiconductor device.
[Fig. 11] Fig. 11 is a view showing results of the simulation of the semiconductor device according to the first embodiment of the present invention in the case where the conditions of impurity irradiation were: 300 keV/1.2×10¹³ cm⁻² for a first well structure and 380 keV/3.6×10¹³ cm⁻² for a second well structure.
[Fig. 12] Fig. 12 is a view showing results of the simulation of the semiconductor device according to the first embodiment of the present invention in the case where the conditions of impurity irradiation were: 300 keV/1.5×10¹³ cm⁻² for a first well structure and 380 keV/3.6×10¹³ cm⁻² for a second well structure.
[Fig. 13] Fig. 13 is a view showing results of the simulation of the semiconductor device according to the first embodiment of the present invention in the case where the conditions of impurity irradiation were: 300 keV/1.8×10¹³ cm⁻² for a first well structure and 380 keV/3. 6×10¹³ cm⁻² for a second well structure.
[Fig. 14] Fig. 14 is a view showing results of the simulation of the semiconductor device according to the first embodiment of the present invention in the case where the conditions of impurity irradiation were: 250 keV/6.0×10¹² cm⁻² for a first well structure and 380 keV/3.6×10¹³ cm⁻² for a second well structure.
[Fig. 15] Fig. 15 is a view showing results of the simulation of the semiconductor device according to the first embodiment of the present invention in the case where the conditions of impurity irradiation were: 300 keV/6.0×10¹² cm⁻² for a first well structure and 380 keV/3.6×10¹³ cm⁻² for a second well structure.
[Fig. 16] Fig. 16 is a view showing results of the simulation of the semiconductor device according to the first embodiment of the present invention in the case where the conditions of impurity irradiation were: 250 keV/1.2×10¹³ cm⁻² for a first well structure and 380 keV/3.6×10¹³ cm⁻² for a second well structure.
[Fig. 17] Fig. 17 is a view showing results of the simulation of the semiconductor device according to the first embodiment of the present invention in the case where the conditions of impurity irradiation were: 250 keV/1.5×10¹³ cm⁻² for a first well structure and 380 keV/3.6×10¹³ cm⁻² for a second well structure.
[Fig. 18] Fig. 18 is a view showing results of the simulation of the semiconductor device according to the first embodiment of the present invention in the case where the conditions of impurity irradiation were: 250 key/1.8×10¹³ cm⁻² for a first well structure and 380 keV/3.6×10¹³ cm⁻² for a second well structure.
[Fig. 19] Fig. 19 is a view showing results of the simulation of the semiconductor device according to the first embodiment of the present invention in the case where the conditions of impurity irradiation were: 200 keV/8.0×10¹² cm⁻² for a first well structure and 300 keV/4.0×10¹² cm⁻² for a second well structure.
[Fig. 20] Fig. 20 is a view showing results of the simulation of the semiconductor device according to the first embodiment of the present invention in the case where the conditions of impurity irradiation were: 200 keV/1.2×10¹³ cm⁻² for a first well structure and 300 keV/6.0×10¹² cm⁻² for a second well structure.
[Fig. 21] Fig. 21 is a view showing results of the simulation of the conventional semiconductor device in the case where the conditions of impurity irradiation were 380 keV/1.8×10¹³ cm⁻² for a first well structure.
[Fig. 22] Fig. 22 is a view showing results of the simulation of the conventional semiconductor device in the case where the conditions of impurity irradiation were 380 keV/3.6×10¹³ cm⁻² for a first well structure.
[Fig. 23] Fig. 23 is a schematic plan view of a semiconductor device according to a second embodiment of the present invention.
[Fig. 24] Fig. 24 is a schematic cross-sectional view of a semiconductor device according to a third embodiment of the present invention.
[Fig. 25] Fig. 25 is a schematic cross-sectional view of a conventional semiconductor device.

### Explanation of Reference numerals

1... N-TYPE EPITAXIAL LAYER
2... P-TYPE WELL CONTACT REGION
3... P-TYPE WELL REGION
4... P-TYPE WELL EXTENSION REGION
5... N⁺-TYPE SOURCE REGION
6... GATE INSULATING FILM
7... GATE ELECTRODE
8... INTERLAYER INSULATING LAYER
9... SOURCE ELECTRODE
10... DRAIN ELECTRODE
11... SUBSTRATE
21... N-TYPE EPITAXIAL LAYER
22... P-TYPE WELL CONTACT REGION
23... P-TYPE WELL REGION
24... P-TYPE WELL EXTENSION REGION
25... N⁺-TYPE EMITTER REGION
26... GATE INSULATING FILM
27... GATE ELECTRODE
28... INTERLAYER INSULATING FILM
29... EMITTER ELECTRODE
30... COLLECTOR ELECTRODE
31... SUBSTRATE

### BEST MODES FOR CARRYING OUT THE INVENTION

Hereinafter, semiconductor devices according to embodiments of the present invention will be described with reference to the drawings. In the following description of the drawings, same or similar portions are given same or similar reference numerals. The drawings are schematic and are different from the real ones. It should be noted that some portions have different dimensional relationship and proportions in the drawings.

### [First Embodiment]

### (Structure of Semiconductor Device)

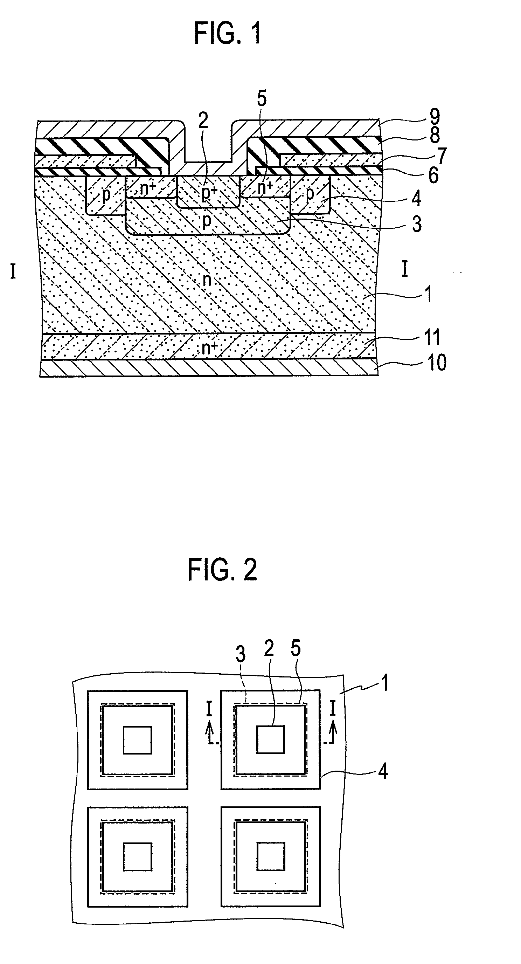

A power MOSFET as a semiconductor device according to a first embodiment of the present invention is described with reference to Figs. 1 and 2.

As shown in Fig. 1, the power MOSFET of the first embodiment includes: a substrate 11 which contains silicon carbide and includes a first main electrode region; a first conductivity-type epitaxial layer 1 which is stacked on the front surface of the substrate 11 and is made of silicon carbide; first conductivity-type second main electrode regions 5 arranged away from each other in a surface layer of the epitaxial layer 1; a second conductivity-type well contact region 2 sandwiched by the second main electrode regions 5; a second conductivity-type well region 3 arranged in contact with surfaces of the second main electrode regions 5 and the second conductivity-type well contact region 2 on the substrate 11 side; second conductivity-type well extension regions 4 arranged to sandwich the second main electrode regions 5 and the second conductivity-type well region 3; gate electrodes 7 arranged on surfaces of the second conductivity-type well extension regions 4 with gate insulating films 6 interposed therebetween, each second conductivity-type well extension region 4 being sandwiched by the corresponding one of the second main electrode regions 5 and a surface exposed portion of the epitaxial layer 1; a second main electrode 9 arranged in contact with the surfaces of the second main electrode regions 5 and the second conductivity-type well contact region 2 in a shared manner; and a first main electrode 10 arranged on a rear surface of the substrate 11 opposite to the front surface. The concentration of a second conductivity-type impurity contained in the second conductivity-type well region 3 has a peak concentration at a deeper position than the position of a peak concentration of a second conductivity-type impurity contained in the second conductivity-type well extension regions 4 in the depth direction from the surface of the epitaxial layer 1 toward the substrate 11.

Herein, the main electrode regions refer to semiconductor regions positioned at both ends of the passage of main current, and the main electrodes refer to main electrodes such as drain and source electrodes.

The substrate 11 including the first main electrode region is first conductivity type. The first electrode region is a drain region, and each second main electrode region 5 is a source region. The first and second main electrodes 10 and 9 are drain and source electrodes, respectively.

The first and second conductivity types are opposite to each other. When the first conductivity type is n-type, the second conductivity type is p-type. When the first conductivity type is p-type, the second conductivity type is n-type. In the following description, the first and second conductivity types are n-type and p-type, respectively.

The substrate 11 containing silicon carbide (SiC) includes an n⁺-type SiC semiconductor having a relatively high n-type impurity concentration. On the front surface of the substrate 11, the n-type SiC semiconductor epitaxial layer 1 having an n-type impurity concentration lower than that of the substrate 11 is provided.

Fig. 2 is a plan view showing an example of the structure of each impurity region arranged in the surface layer of the epitaxial layer 1. In Fig. 2, the gate insulting film 6, gate electrode 7, interlayer insulating layer 8, and source electrode 9 are omitted. A cross-sectional view taken along a line I-I of Fig. 2 is shown in Fig. 1.

In the example shown in Fig. 2, the n⁺-type source region 5 has a rectangular frame shape in a plan view, and the p-type well contact region 2 is surrounded by the rectangular frame of the n⁺-type source region 5. The p-type well region 3 is provided in contact with the surface of the n⁺-type source region 5 and p-type well contact region 2 on the substrate 11 side. The p-type well extension region 4 is provided so as to sandwich side surfaces of the n⁺-type source region 5 and p-type well region 3.

The depth of the surface of the p-type well region 3 on the substrate 11 side from the surface of the epitaxial layer 1 is greater than that of the surfaces of the p-type well extension regions 4 on the substrate 11 side.

In each region, the depth of the p-type well contact region 2 from the surface of the epitaxial layer 1 is 0.2 to 0.5 µm; the n⁺-type source regions 5, 0.05 to 0.1 µm; the p-type well region 3, 0.2 to 0.7 µm; and the p-type well extension regions 4, 0.15 to 0.5 µm.

The gate insulating films 6 and gate electrodes 7 are sequentially stacked on the epitaxial layer 1. The gate insulating films 6 are made of silicon oxide (SiO₂), for example, and are each provided over the outer periphery of the corresponding n⁺-type source region 5 to the outside of the corresponding p-type well extension region 4 to cover the surface of the epitaxial layer 1 between the outer periphery of the n⁺-type source regions 5 and the outside of the p-type well extension region 4.

The gate electrodes 7 are made of polycrystalline silicon, for example, and are connected to an external electrode terminal.

The interlayer insulating layers 8 are made of SiO₂, for example, and are each provided to cover the corresponding gate insulating film 6 and gate electrode 7 for insulation between the source electrode 9 and the gate electrode 7.

The source electrode 9 is made of metal such as aluminum (Al), for example, and has a rectangular shape in a plan view. The source electrode 9 is provided on the interlayer insulating layer 8 and is connected to a source contact region including a surface of the inner periphery of the n⁺-type source region 5 and a surface of the p-type well contact region 2. The source electrode 9 may be connected to the source contact region through a metallic thin film made of Ni or the like.

The drain electrode 10 is made of metal such as Al, for example, and is provided on the rear surface of the substrate 11 (opposite to the epitaxial layer 1) so as to cover the entire rear surface of the substrate 11.

In order to ensure the withstand voltage of the semiconductor device, preferably, a guard ring (not shown) containing a p-type impurity is provided near the surface of the outer periphery of the epitaxial layer 1.

The peak concentration position of the p-type impurity contained in the p-type well region 3 is deeper than the peak concentration position of the p-type impurity contained in the p-type well extension region 4 in a depth direction from the surface of the epitaxial layer 1 toward the substrate 11.

Preferably, the p-type impurity concentration of the p-type well region 3 has a peak near the deepest portion (the boundary with the epitaxial layer 1) and continuously and gradually decreases toward the surface.

For example, the peak concentration of the p-type impurity of the p-type well region 3 is 2×10¹⁷ to 3×10¹⁸ cm⁻³ and preferably, 4×10¹⁷ to 2×10¹⁸ cm⁻³. The position of the peak concentration of the p-type impurity is 0.3 to 0.6 µm and preferably 0.4 to 0.5 µm.

Preferably, the p-type impurity concentration of the p-type well extension region 4 has a peak near the deepest portion (the boundary with the epitaxial layer 1) and continuously and gradually decreases toward the surface.

For example, the peak concentration of the p-type impurity of the p-type well extension region 4 is 1×10¹⁷ to 2×10¹⁸ cm⁻³ and preferably, 5×10¹⁷ to 1×10¹⁸ cm⁻³. The p-type impurity concentration near the surface is not more than 1×10¹⁶ cm⁻³ and preferably not more than 5×10¹⁵ cm⁻³. The position of the peak concentration of the p-type impurity is 0.2 to 0.5 µm and preferably 0.3 to 0.4 µm.

The p-type well contact region 2 preferably has an average p-type impurity concentration higher than those of the p-type well region 3 and p-type well extension region 4. The higher average p-type impurity concentration reduces the on resistance.

### (Operation Principle)

The operation principle of the power MOSFET according to the first embodiment of the present invention is as follows.

Positive voltage is applied to the gate electrode 7. By the application of voltage, an inversion layer is formed in the surface layer portion of the p-type well extension region 4 under the gate electrode 7, and the n⁺-type source region 5 and epitaxial layer 1 are electrically connected through the inversion layer. This allows current to flow from the drain electrode 10 provided on the rear surface of the substrate 11 under the epitaxial layer 1 to the source electrode 9 provided on the surface of the n⁺-type source region 5. In other words, the current can be controlled by the voltage applied to the gate electrode.

### (Manufacturing Method)

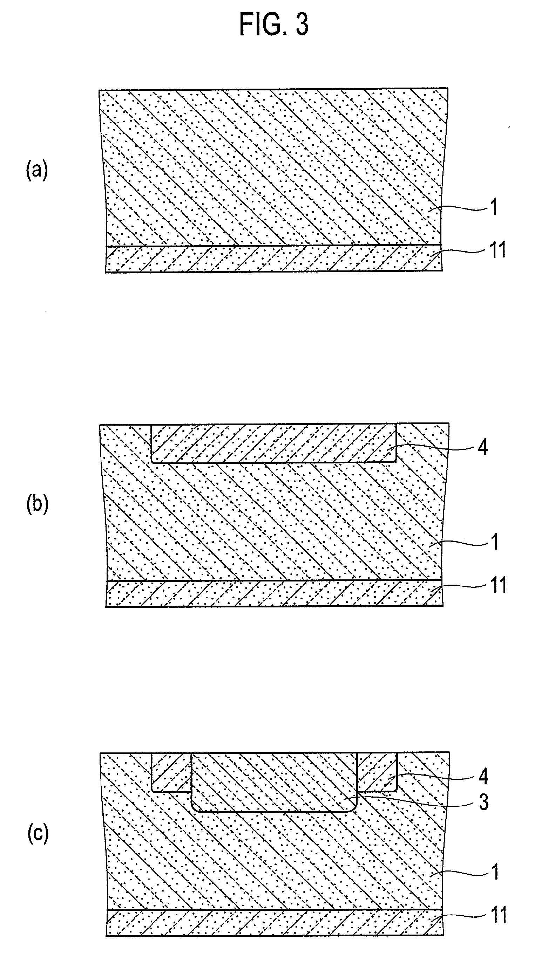

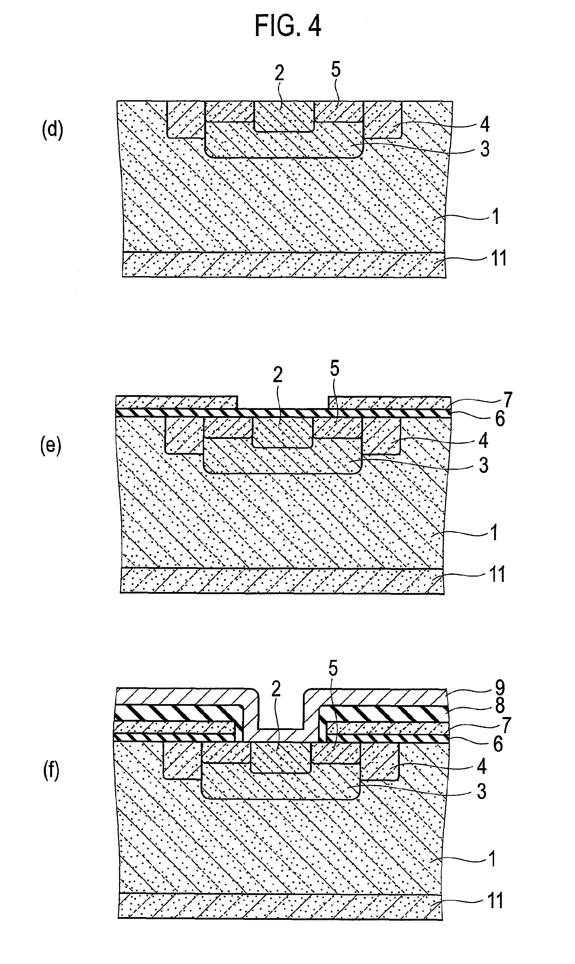

Figs. 3 and 4 are views for explaining a method of manufacturing the semiconductor device according to the first embodiment of the present invention.

The method of manufacturing the semiconductor device according to the first embodiment of the present invention includes: a step of forming the first conductivity-type epitaxial layer 1 made of silicon carbide on a front surface of the substrate 11 including the first main electrode region containing silicon carbide; a step of implanting ions of a second conductivity-type impurity into a surface layer of the epitaxial layer 1 using the second conductivity-type mask to form a second conductivity-type well extension region 4; a step of implanting ions of a second conductivity-type impurity into the surface layer of the epitaxial layer 1 using a first conductivity-type mask to form the second conductivity-type well region 3; and a step of implanting ions of the first conductivity-type impurity using a first conductivity-type mask to form the first conductivity-type second main electrode region 5.

Hereinafter, the manufacturing steps are described in detail.

1 (a) First, as shown in Fig. 3(a), an n-type SiC semiconductor which is the same as the material of the substrate 11 is epitaxially grown on the front surface of the substrate 11 in which the n⁺-type SiC semiconductor is formed so as to form the epitaxial layer 1.

(b) Next, as shown in Fig. 3(b), the p-type impurity is doped into the surface layer portion of the epitaxial layer 1 by ion implantation under irradiation conditions of 250 keV implantation energy and 1.8×10¹³ cm⁻² dose using a p-type region mask which allows the guard ring portion to be simultaneously formed so as to form the p-type well extension region 4.

The p-type impurity can be B, Al, In, Ga, or the like and is preferably B or Al.

Herein, by adjusting the implantation energy, the depth to which the p-type impurity is formed can be controlled. By adjusting the dose, the concentration of the p-type impurity can be controlled.

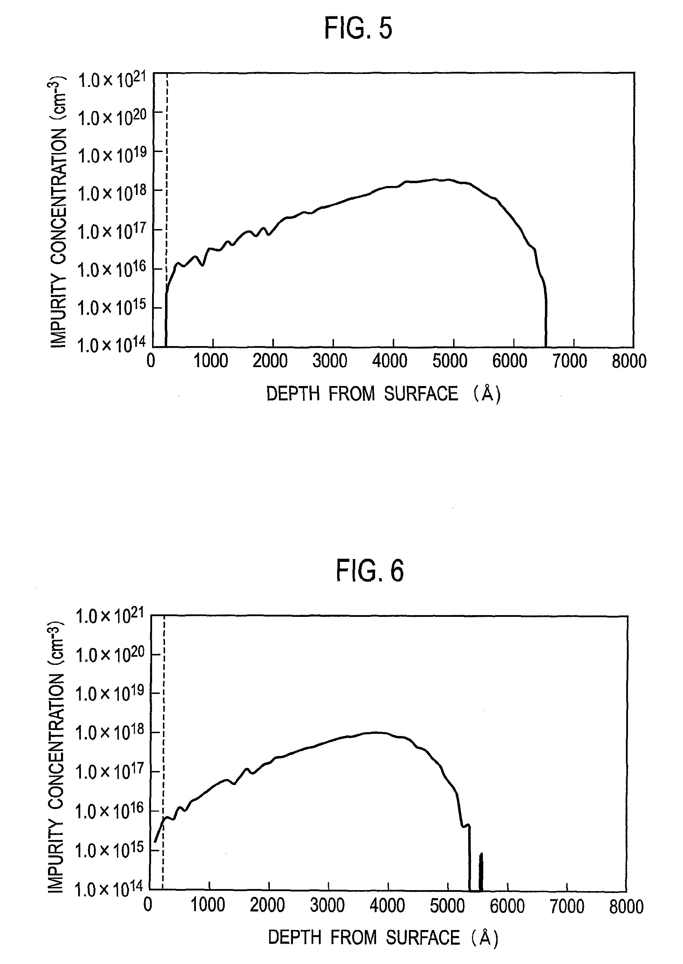

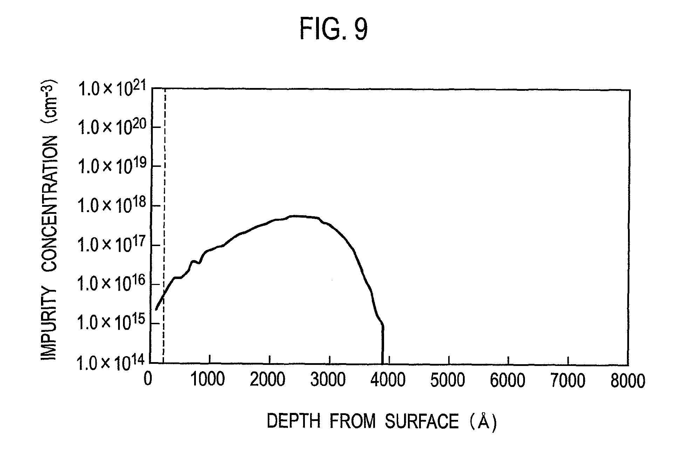

Figs. 5 to 9 show examples of the impurity concentrations in the depth direction from the surface of the epitaxial layer 1 which are obtained with different implantation energies and doses.

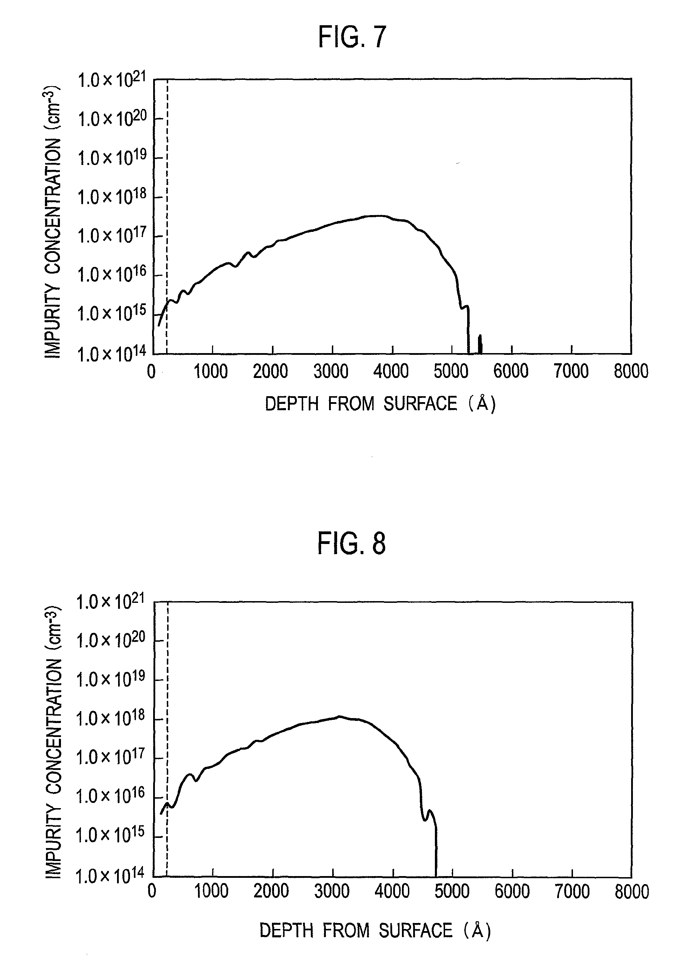

Fig. 8 is a view showing an example of the concentration of the p-type impurity contained in the p-type well extension region 4 in the depth direction, which is obtained under the aforementioned conditions. The peak concentration is at a depth of about 0.31 µm from the surface of the epitaxial layer 1. The concentration of the p-type impurity is about 1×10¹⁸ cm⁻³ at the position of the peak concentration and is about 5×10¹⁵ cm⁻³ near the surface.

(c) Next, as shown in Fig. 3(c), the p-type well region 3 is formed by doping Al as a p-type impurity into the surface layer of the epitaxial layer 1 using ion implantation with an n-type source region forming mask under the irradiation condition of 380 keV implantation energy and 3.6×10¹³ cm⁻² dose. The p-type well region 3 can effectively prevent vertical punch through because of the impurity concentration of the p-type well region 3 in addition to the impurity concentration of the p-type well extension region 4. Furthermore, the p-type well region 3 has no relation with the channel region, and therefore, the high impurity concentration in the surface does not affect on the mobility.

Fig. 5 is a view showing an example of the concentration of the p-type impurity included in the p-type well region 3 in the depth direction, which is obtained under the aforementioned irradiation conditions. The depth of the position of the peak concentration from the surface of the epitaxial layer 1 is greater than that of the p-type well extension region 4 because the implantation energy is higher than that for forming the p-type well extension region 4. The depth of the peak concentration is about 0.48 µm. The p-type impurity concentration at the position of the peak concentration is about 2×10¹⁸ cm⁻².

(d) Next, as shown in Fig. 4(d), the n⁺-type source region 5 is formed by implanting ions of the n-type impurity using ion implantation with the same n-type source region forming mask. Subsequently, the p-type well contact region 2 is formed using a p-type well contact region forming mask.

The n-type impurity can be N, P, As, Sb, or the like and is preferably N or P.

(e) Next, as shown in Fig. 4(e), the gate insulating film 6 is formed by thermally oxidizing the surface of the epitaxial layer 1 using pyrogenic oxidation. Thereafter, polycrystalline silicon is formed using reduced-pressure CVD (chemical vapor deposition), and the gate electrode 7 is then formed using photolithography.

(f) Next, as shown in Fig. 4(f), the interlayer insulating layer 8 is formed by thermal oxidation using pyrogenic oxidation. Thereafter, the source electrode 9 is formed by using RIE (reactive ion etching) to expose an electrode contact portion of the surface of the epitaxial layer 1 and then depositing aluminum or the like thereon.

(g) Finally, the drain electrode 10 is formed by depositing aluminum or the like on the rear surface of the substrate 11, thus completing the semiconductor device shown in Fig. 1.

With such a manufacturing method, it is possible to manufacture the semiconductor device including a double p-well structure in which the p-type well region 3 and p-type well extension region 4 individually have peak p-type impurity concentrations at different depths.

### (Simulation)

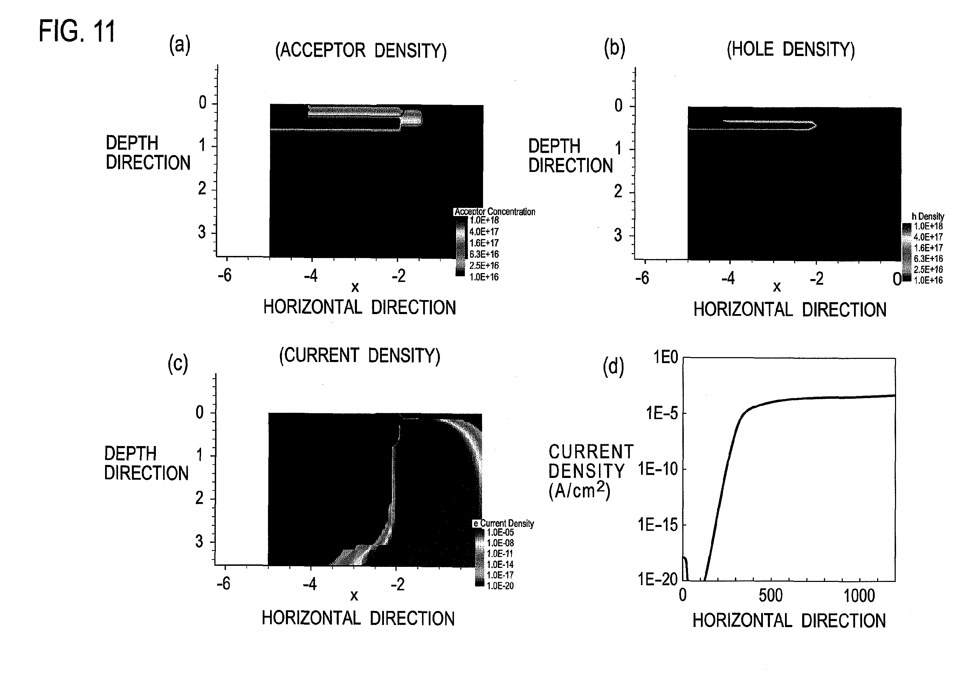

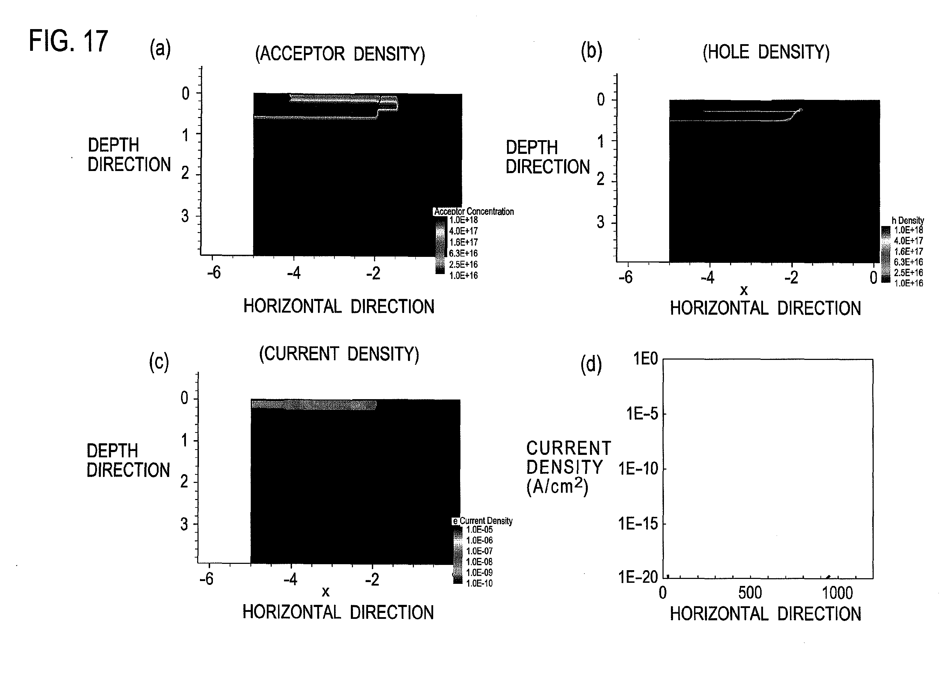

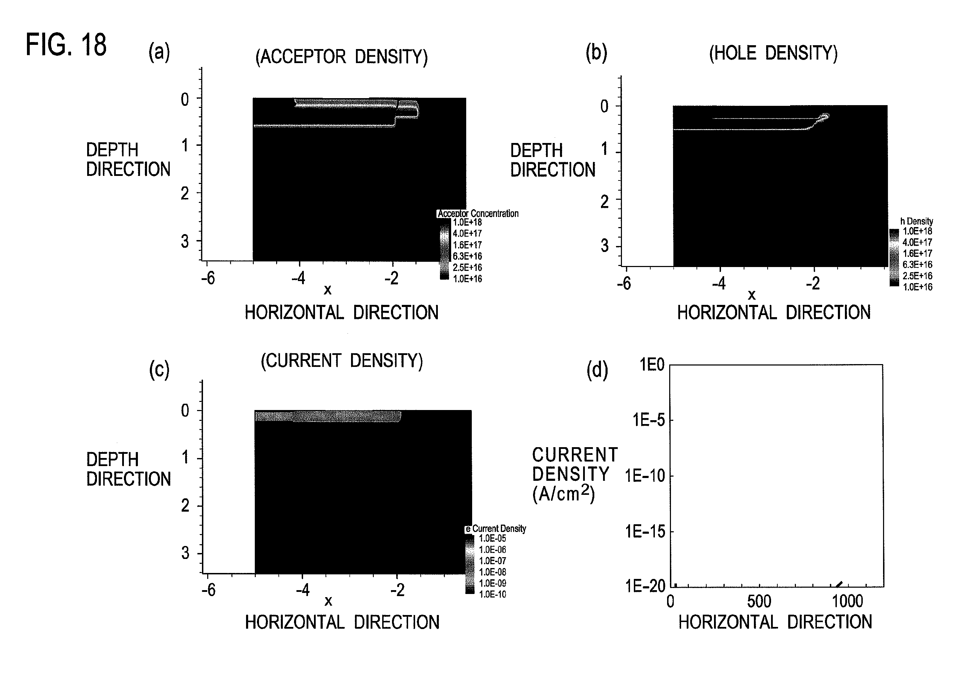

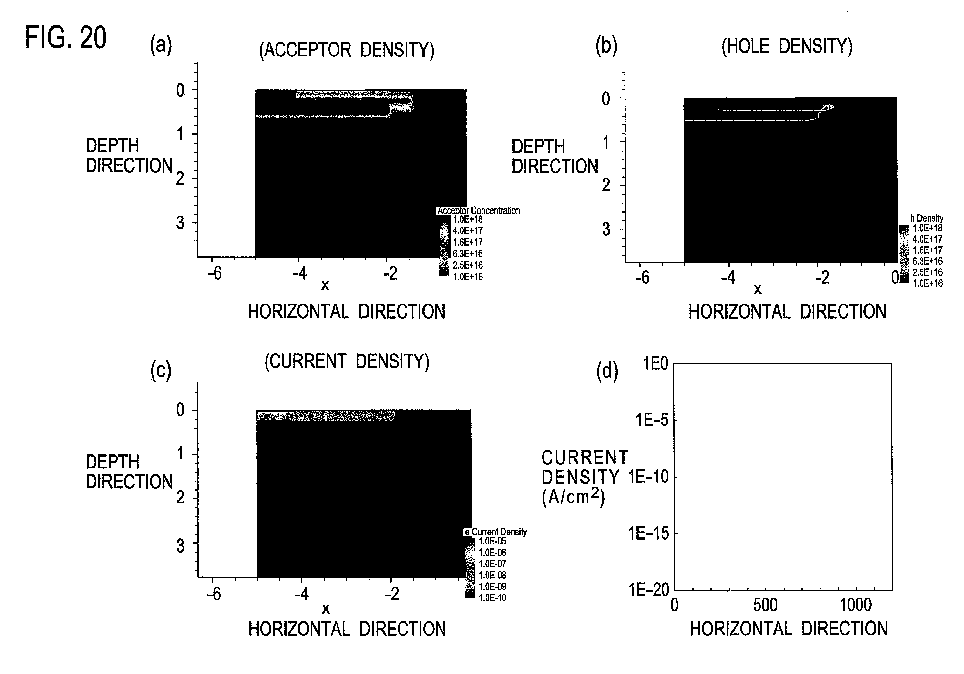

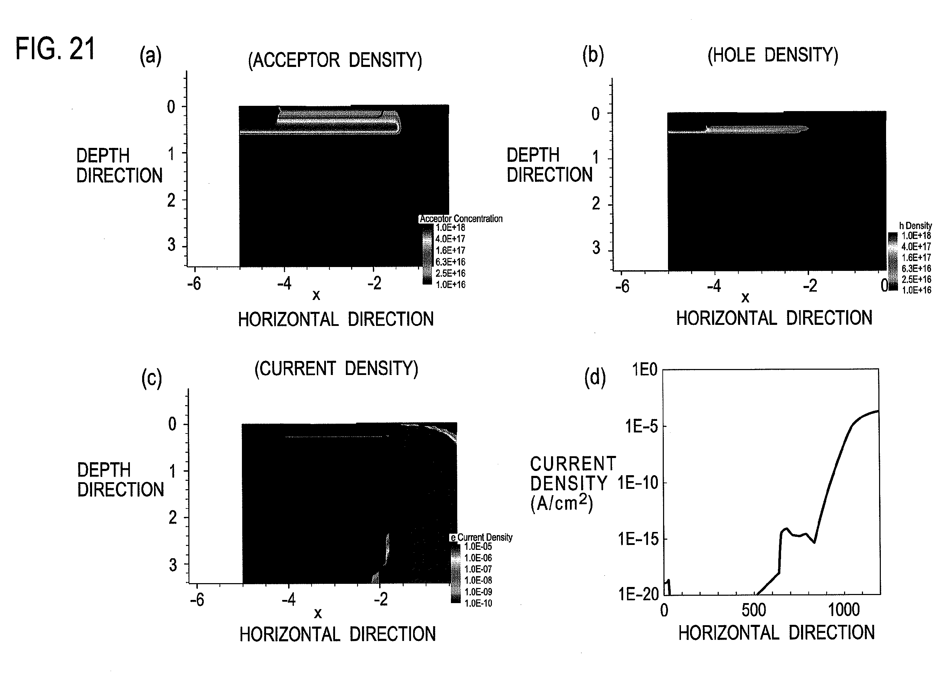

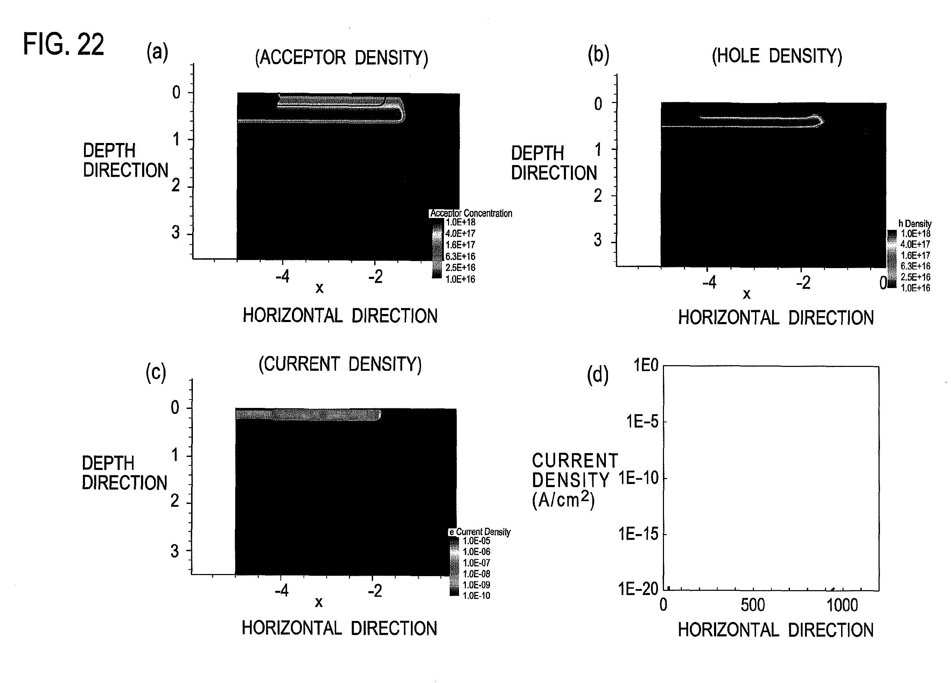

Figs. 11 to 20 show results of simulation of the semiconductor device according to the first embodiment of the present invention, and Figs. 21 and 22 show results of simulation of a conventional semiconductor device. (a) to (c) of each of Figs. 11 to 22 indicate an acceptor density distribution, a hole density distribution, and a current density distribution in two dimensions including a horizontal direction (unit: 10⁻⁶ m) and a depth direction (unit: 10⁻⁶ m), respectively. In (d), the horizontal axis represents the horizontal direction (unit: 10⁻¹⁰ m) from the interface between the n⁺-type source region 5 and p-type well extension region 4 toward the p-type well extension region 4 with the interface set to zero, and the vertical axis represents current density.

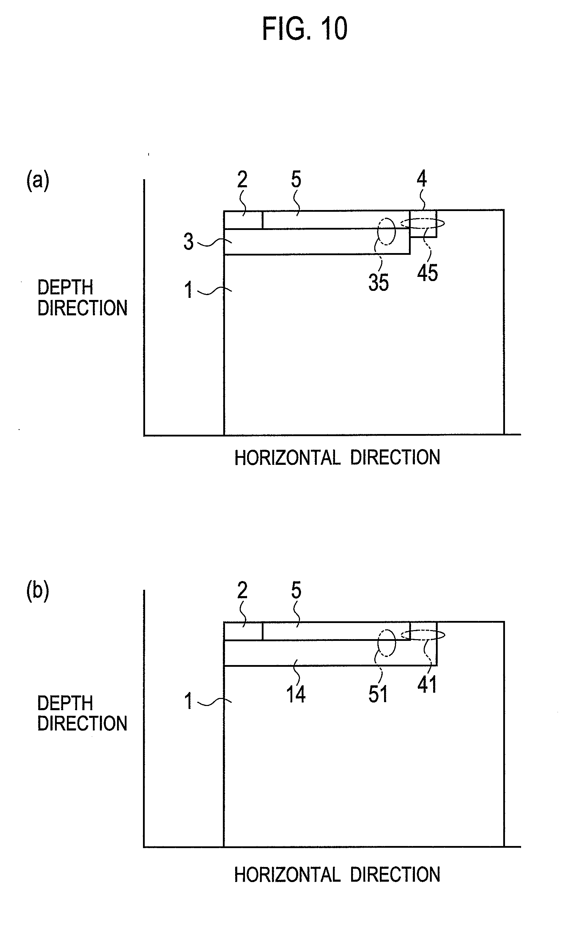

Fig. 10 is a view showing shape models in the simulation. Fig. 10(a) corresponds to the positions in the horizontal and depth directions of each of (a) to (c) of Figs. 11 to 20. Fig. 10 (b) corresponds to the positions in the horizontal and depth directions of each of (a) to (c) of Figs. 21 and 22.

The doping of the p-type impurity (acceptors) is performed by irradiation with different implantation energies and doses for the first p-well 4 (p-type well region 4) and the second p-well 3 (p-type well extension region 3).

As for the semiconductor device obtained as described above, reverse voltage is applied across the source and drain electrodes and is increased for simulation using known device simulation means.

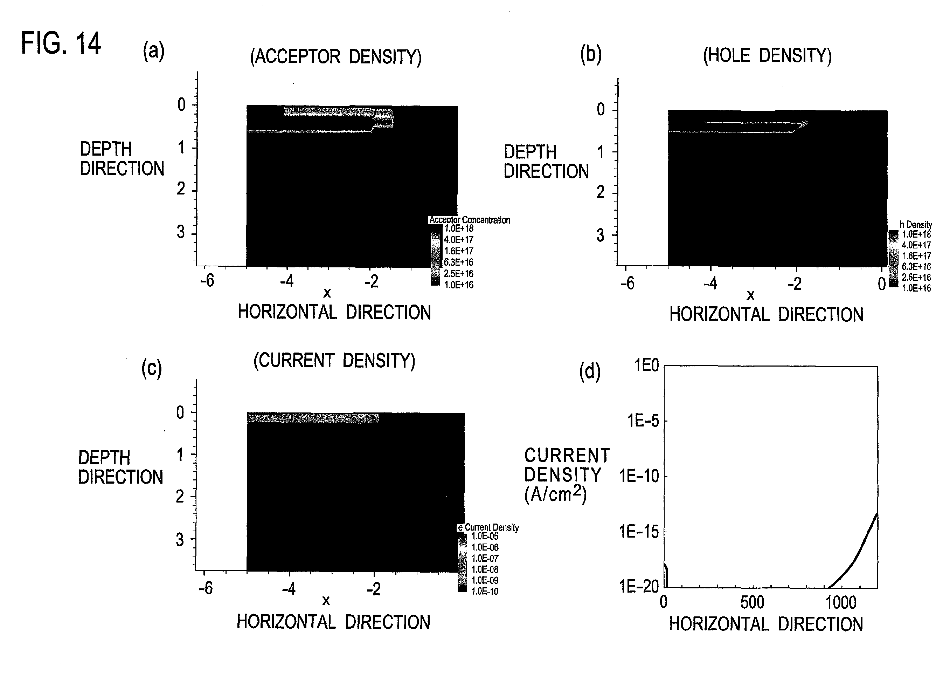

As shown in Figs. 14, 17, 18, and 20, no punch through occurs in a horizontal direction 45 at the first p-well 4 and in a vertical direction 35 at the second p-well 3 even with a withstand voltage of 1200 V. There is no current flowing through the epitaxial layer 1, exhibiting high withstand voltage.

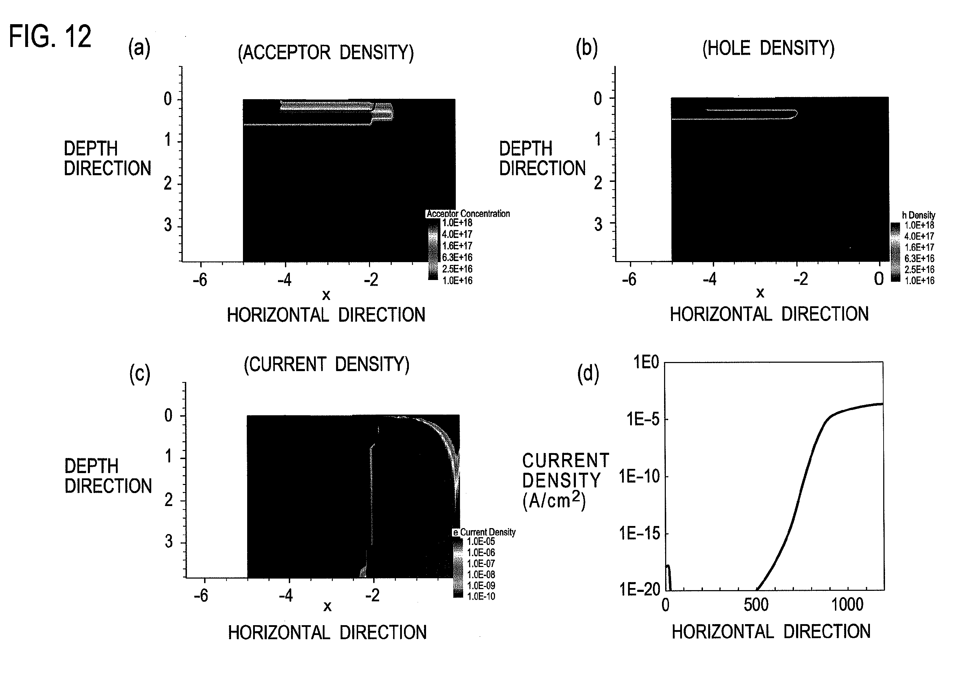

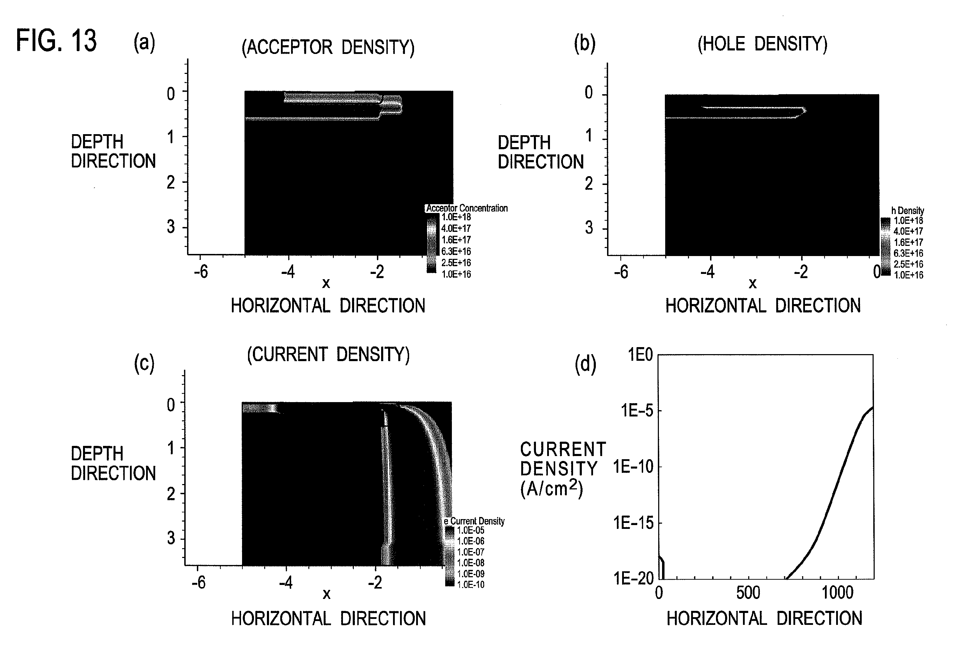

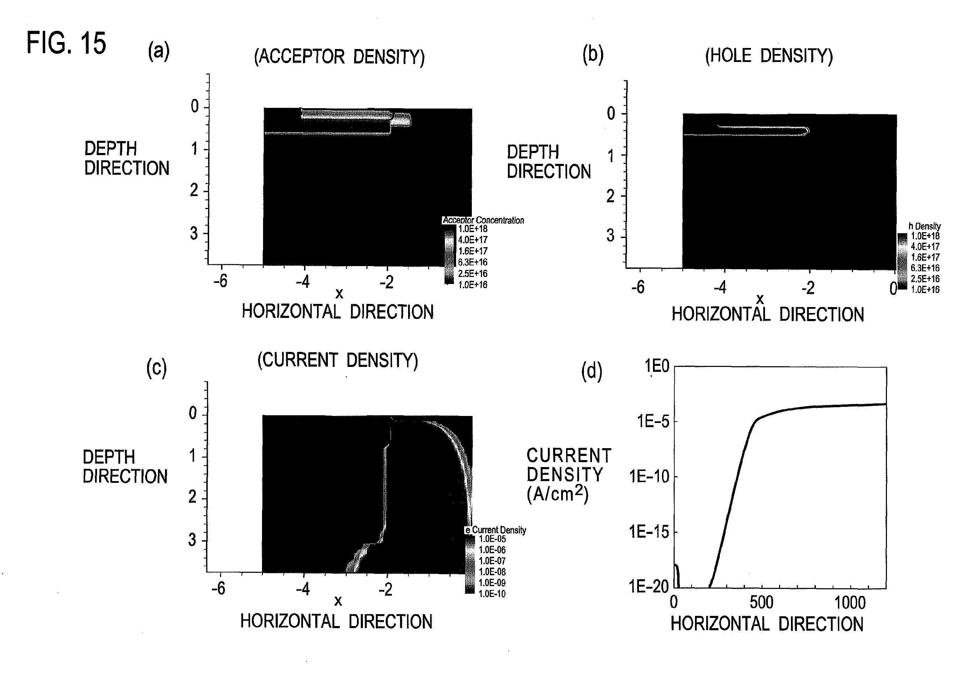

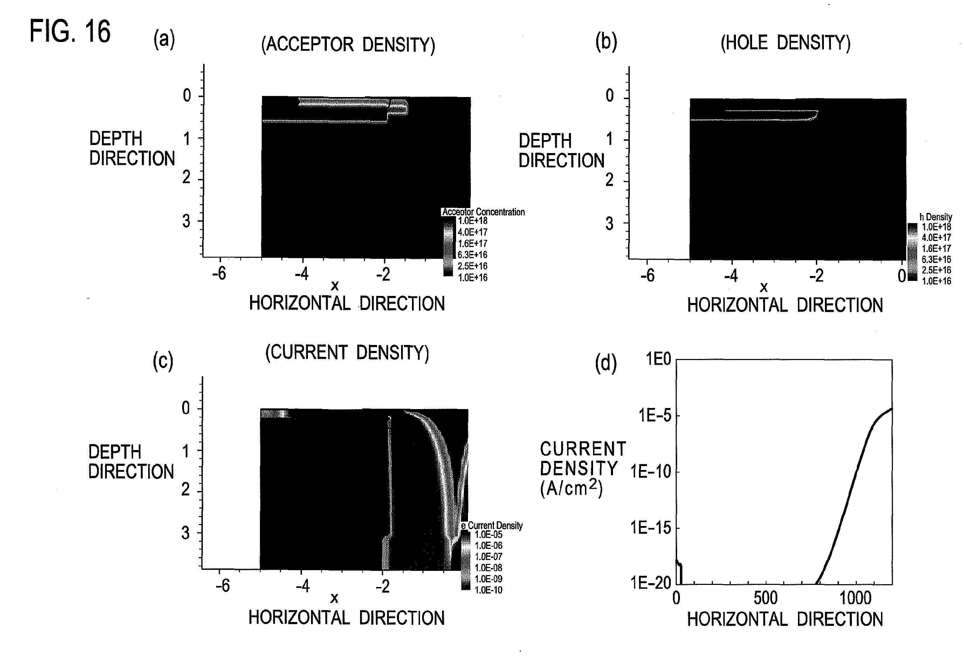

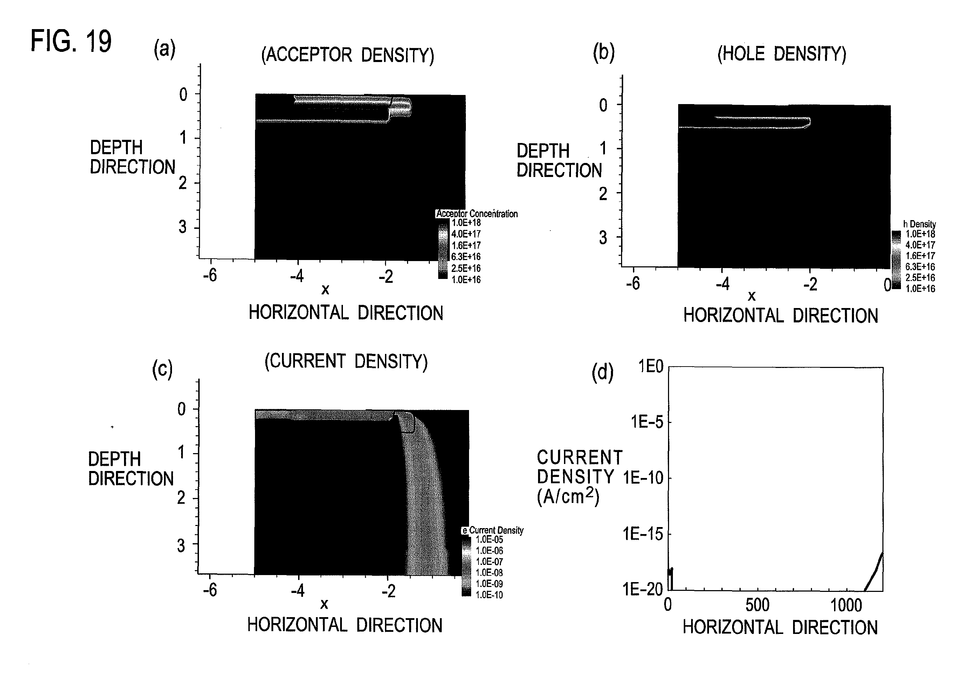

As shown in Figs. 11 to 13, 15, 16, and 19, punch through occurs under the impurity irradiation conditions thereof. However, the withstand voltage just before the punch through occurs are 120 V in Fig. 11, 500 V in Fig. 12, 700 V in Fig. 13, 200 V in Fig. 15, 800 V in Fig. 16, and 1100 V in Fig. 19. The withstand voltages thereof were thus high.

On the other hand, as for the conventional semiconductor device, in a semiconductor device including a single p-well 14 formed under the irradiation conditions of 380 keV implantation energy and 1.8×10¹³ cm⁻² dose for doping the p-type impurity (acceptor), as shown in Fig. 21, punch through occurs with a withstand voltage of 500 V in horizontal and vertical directions 41 and 51 at the single p-well 14, allowing current to flow through the epitaxial layer 1.

In the aforementioned conventional semiconductor device, when the dose is increased to 3.6×10¹³ cm⁻², as shown in Fig. 22, there is no punch through caused even for a withstand voltage of 1200 V. However, the mobility in the channel region is reduced.

According to the first embodiment of the present invention, the p well structure is a double well structure, and the p-type impurity concentration is high in deep portion of the first p-well 4. Accordingly, it is possible to prevent punch through from occurring in the horizontal direction 45 at the p-well 4 even when reverse potential is applied. Moreover, since the p-type impurity concentration is high in deep portion of the second p-well 3, it is possible to prevent punch through from occurring in the vertical direction 35 at the second p-well 3.

According to the first embodiment of the present invention, the concentration of the p-type impurity is low near the surface of the first p-well 4. It is therefore possible to secure good mobility and reduce the on resistance.

According to the first embodiment of the present invention, at forming the n⁺-type source region 5 and then forming the p-well 3, the same n-type mask is used. Accordingly, the voltage withstanding structure can be formed without an increase in number of the manufacturing steps.

According to the first embodiment of the present invention, the p-well structure is the double well structure. Accordingly, even at a manufacturing process of forming the first p-well 4 together with a guard ring, the impurity concentration of the guard ring can be set to a desired value.

The semiconductor device according to the first embodiment of the present invention has improved withstand voltage characteristics and can be manufactured with a simpler manufacturing process.

### [Second Embodiment]

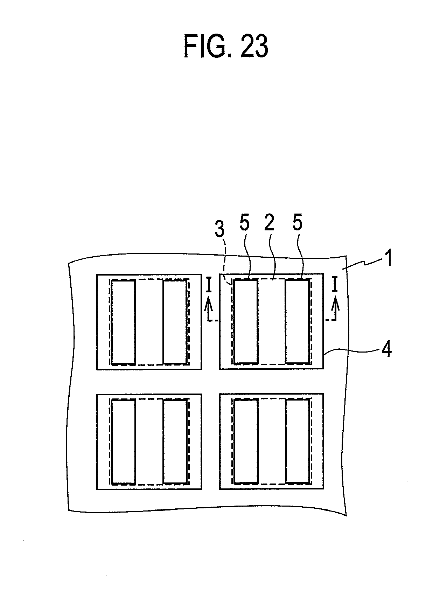

A semiconductor device according to a second embodiment of the present invention is described with reference to Fig. 23. In the second embodiment, same portions as those of the first embodiment are given same reference numerals or symbols, and the redundant description is omitted.

Fig. 23 is a plan view showing an example of a structure of impurity regions arranged in the surface layer of the epitaxial layer 1. In Fig. 23, the gate insulating film 6, gate electrode 7, interlayer insulating layer 8, and source electrode 9 are omitted. The cross-sectional view taken along a line I-I of Fig. 23 is shown in Fig. 1.

As shown in Fig. 23, in the semiconductor device according to the second embodiment of the present invention, n⁺-type source regions 5 rectangular in a plan view are arranged away from each other, and the p-type well contact region 2 is arranged between the n⁺-type source regions 5. The other constitution is the same as that of the first embodiment, and the description thereof is omitted.

The method of manufacturing the semiconductor device according to the second embodiment is different from the method of manufacturing the semiconductor device according to the first embodiment in terms of the method of forming the n⁺-source regions 5. The others are the same as those of the first embodiment, and the description thereof is omitted.

The semiconductor device according to the second embodiment of the present invention has improved withstand voltage characteristics and can be manufactured with the simpler manufacturing process.

### [Third Embodiment]

### (Structure of Semiconductor Device)

IGBT as a semiconductor device according to a third embodiment of the present invention is described with reference to Fig. 24. In the third embodiment, same portions as those of the first embodiment are given same reference numerals or symbols, and the redundant description is omitted.

As shown in Fig. 24, the IGBT of the third embodiment includes: a substrate 31 which contains silicon carbide and includes a first main electrode region; a first conductivity-type epitaxial layer 21 which is stacked on a front surface of the substrate 31 and is made of silicon carbide; first conductivity-type second main electrode regions 25 arranged away from each other in a surface layer of the epitaxial layer 21; a second conductivity-type well contact region 22 sandwiched by the second main electrode regions 25; a second conductivity-type well region 23 arranged in contact with surfaces of the second main electrode regions 25 and the second conductivity-type well contact region 22 on the substrate 31 side; second conductivity-type well extension regions 24 arranged to sandwich the second main electrode regions 25 and the second conductivity-type well region 23; gate electrodes 27 arranged on surfaces of the second conductivity-type well extension regions 24 with gate insulating films 26 interposed therebetween, each second conductivity-type well extension region 24 being sandwiched by the corresponding second main electrode regions 25 and a surface exposed portion of the epitaxial layer 21; a second main electrode 29 arranged in contact with the surfaces of the second main electrode regions 25 and the second conductivity-type well contact region 22; and a first main electrode 30 arranged on a rear surface of the substrate 31 opposite to the front surface. The concentration of a second conductivity-type impurity contained in the second conductivity-type well region 23 has a peak concentration at a deeper position than the position of peak concentration of a second conductivity-type impurity contained in the second conductivity-type well extension regions 24 in the depth direction from the surface of the epitaxial layer 21 toward the substrate 31.

The substrate 31 including the first main electrode region is of second conductivity type. The first main electrode region is a collector region, and each second main electrode region 25 is an emitter region. The first and second main electrodes 30 and 29 are collector and emitter electrodes, respectively.

In the following description, the first and second conductivity types are n- and p-type, respectively.

The substrate 31 containing silicon carbide (SiC) includes a p⁺-type SiC semiconductor with a relatively high p-type impurity concentration. On the front surface of the substrate 31, the n-type SiC semiconductor epitaxial layer 21 is provided.

In the surface layer of the epitaxial layer 21, the n⁺-type emitter regions 25 which are rectangular in a plan view are arranged away from each other, and the p-type well contact region 22 is sandwiched by the n⁺-type emitter regions 25. The p-type well region 23 is provided in contact with the surfaces of the n⁺-type emitter regions 25 and p-type well contact region 22 on the substrate 31 side. The p-type well extension regions 24 are arranged so as to sandwich the side surfaces of the n⁺-type emitter regions 25 and p-type well region 23.

The depth of the surface of the p-type well region 23 on the substrate 31 side from the surface of the epitaxial layer 21 is greater than that of the surface of each p-type well extension region 24 on the substrate 31 side.

In each region, the p-type well contact region 22 has a depth from the surface of the epitaxial layer 21 of 0.2 to 0.5 µm; the n⁺-type emitter regions 25, 0.05 to 0.1 µm; the p-type well region 23, 0.2 to 0.7 µm; and the p-type well extension regions 24, 0.15 to 0.5 µm.

The gate insulating films 26 and gate electrodes 27 are sequentially stacked on the epitaxial layer 21. The gate insulating films 26 are made of silicon oxide (SiO₂), for example, and are each provided over the outer periphery of the corresponding n⁺-type emitter region 25 to the outside of the corresponding p-type well extension region 24 to cover the surface of the epitaxial layer 21 between the outer periphery of the n⁺-type emitter region 25 and the outside of the p-type well extension region 24.

The gate electrodes 27 are made of polycrystalline silicon, for example, and are connected to an external electrode terminal.

The interlayer insulating layers 28 are made of SiO₂, for example, and are each provided to cover the corresponding gate insulating film 26 and gate electrode 27 for insulation between the emitter electrode 26 and gate electrode 27.

The emitter electrode 29 is made of metal such as aluminum (Al), for example, and has a rectangular shape in a plan view, for example. The emitter electrode 29 is provided on the interlayer insulating layers 28 and is connected to a contact region including surfaces of inner peripheries of the n⁺-type emitter regions 25 and a surface of the p-type well contact region 22. The emitter electrode 29 may be connected to the contact region through a metallic thin film made of Ni or the like.

The collector electrode 30 is made of metal such as Al, for example, and is provided on the rear surface of the substrate 31 (on the opposite side to the epitaxial layer 21) so as to cover the entire rear surface of the substrate 31.

In order to secure the withstand voltage of the semiconductor device, preferably, a guard ring (not shown) containing a p-type impurity is provided near the surface of the outer periphery of the epitaxial layer 21.

The concentration of the p-type impurity contained in the p-type well region 23 is the same as that of the p-type well region 3 in the first embodiment. The concentration of the p-type impurity contained in the p-type well extension regions 24 is the same as that of the p-type well extension region 4 in the first embodiment, and the description thereof is omitted.

### (Operation Principle)

The operation principle of the IGBT according to the third embodiment of the present invention is as follows.

Voltage higher than the emitter voltage is applied to the gate electrodes 27 with negative and positive voltages applied to the emitter and collector electrodes 29 and 30, respectively. The application of voltage allows inversion layers to be formed in surface layer portions of the p-type well extension regions 24 under the gate electrodes 27. Electrons are injected into the substrate 31 through the inversion layers from the emitter regions 25 while holes are injected from the substrate 31 to the epitaxial layer 21. Current therefore flows from the collector electrode 30 provided on the rear surface of the substrate 31 under the epitaxial layer 21 to the emitter electrode 29 provided on the surfaces of the emitter regions 25. The current can be controlled with voltage applied to the gate electrodes 27.

The method of manufacturing the semiconductor device according to the third embodiment is different from the method of manufacturing the semiconductor device according to the first embodiment in terms of the method of forming the substrate 31. The others are the same as those of the first embodiment, and the description thereof is omitted.

The semiconductor device according to the third embodiment of the present invention has improved withstand voltage characteristics and can be manufactured by a simpler manufacturing process.

### [Other Embodiments]

Hereinabove, the present invention is described in detail with the aforementioned first to third embodiments. However, it will be apparent to those skilled in the art that the present invention is not limited to the first to third embodiments. The present invention can be carried out as modifications and variations without departing from the spirit and scope of the present invention determined by the description of claims. Accordingly, the description of the specification is for the purpose of exemplification and explanation and does not have any limitation on the present invention. One of the modifications obtained by partially modifying the first to third embodiments is described later.

The semiconductor devices according to the aforementioned first to third embodiments are described with the first conductivity-type set to n-type and the second conductivity-type set to p-type, but the first and second conductivity-types may be p- and n-types, respectively. Such a structure can provide the same effects as those of the aforementioned first to third embodiments.

## Claims

1. A semiconductor device comprising:
a substrate which contains silicon carbide and includes a first main electrode region;
a first conductivity-type epitaxial layer which is stacked on the a front surface of the substrate and is made of silicon carbide;
first conductivity-type second main electrode regions arranged away from each other in a surface layer of the epitaxial layer;
a second conductivity-type well contact region sandwiched by the second main electrode regions;
a second conductivity-type well region arranged in contact with surfaces of the second main electrode regions and the second conductivity-type well contact region on the substrate side;
second conductivity-type well extension regions arranged to sandwich the second main electrode regions and the second conductivity-type well region;
gate electrodes arranged on surfaces of the second conductivity-type well extension regions with gate insulating films interposed therebetween, each second conductivity-type well extension region being sandwiched by the corresponding one of the second main electrode regions and a surface exposed portion of the epitaxial layer;
a second main electrode arranged in contact with surfaces of the second main electrode regions and the second conductivity-type well contact region in a shared manner; and
a first main electrode arranged on a rear surface of the substrate opposite to the front surface, wherein
concentration of a second conductivity-type impurity contained in the second conductivity-type well region has a peak concentration at a deeper position than the position of a peak concentration of the second conductivity-type impurity contained in the second conductivity-type well extension regions in a depth direction from the surface of the epitaxial layer toward the substrate.

2. The semiconductor device according to claim 1, wherein
the first main electrode region is of a first conductivity type,
the first main electrode region is a drain region,
the second main electrode regions are a source region,
the first main electrode is a drain electrode, and
the second main electrode is a source electrode.

3. The semiconductor device according to claim 1, wherein
the first main electrode region is of a second conductivity type,
the first main electrode region is a collector region,
the second main electrode regions are an emitter region,
the first main electrode is a collector electrode, and
the second main electrode is an emitter electrode.

4. The semiconductor device according to any one of claims 1 to 3, wherein
the concentration of the second conductivity-type impurity at the position of the peak concentration in the second conductivity-type well region is higher than concentration of the second conductivity-type impurity at the position of the peak concentration in each second conductivity-type well extension region.

5. The semiconductor device according to any one of claims 1 to 4, wherein
the depth of the surface of the second conductivity-type well region on the substrate side from the surface of the epitaxial layer is greater than that of the surface of each second conductivity-type well extension region on the substrate side.
